# EUROPÄISCHE PATENTSCHRIFT

(11) **EP 0 966 186 B1**
(45) Veröffentlichungstag und Bekanntmachung des Hinweises auf die Patenterteilung: **07.03.2007**
(21) Anmeldenummer: 99110347.4
(22) Anmeldetag: 28.05.1999
(51) Int. Cl.: H05K 3/00, H05K 3/24, H01L 21/48

(54) **Verfahren zum Herstellen eines Metall-Keramik-Substrates**
Process for manufacturing a metal-ceramic substrate
Procédé de fabrication d'un substrat métal-céramique

(30) Priorität: 19.06.1998 DE 19827414
(43) Veröffentlichungstag der Anmeldung: 22.12.1999
(73) Patentinhaber: Electrovac AG, 3400 Klosterneuburg (AT)
(72) Erfinder: Dr.-Ing. Jürgen Schulz-Harder, 91207 Lauf (DE)
(74) Vertreter: Graf, Helmut

(56) Entgegenhaltungen:
- DE-A- 4 319 944
- PATENT ABSTRACTS OF JAPAN vol. 011, no. 140 (M-586), 8. Mai 1987 (1987-05-08) & JP 61 276795 A (NEC CORP), 6. Dezember 1986 (1986-12-06)
- PATENT ABSTRACTS OF JAPAN vol. 009, no. 258 (E-350), 16. Oktober 1985 (1985-10-16) & JP 60 107845 A (TOSHIBA KK), 13. Juni 1985 (1985-06-13)
- PATENT ABSTRACTS OF JAPAN vol. 017, no. 337 (E-1388), 25. Juni 1993 (1993-06-25) & JP 05 041566 A (DOWA MINING CO LTD), 19. Februar 1993 (1993-02-19)
- PATENT ABSTRACTS OF JAPAN vol. 018, no. 499 (E-1607), 19. September 1994 (1994-09-19) & JP 06 169150 A (MATSUSHITA ELECTRIC WORKS LTD), 14. Juni 1994 (1994-06-14)
- PATENT ABSTRACTS OF JAPAN vol. 017, no. 238 (E-1363), 13. Mai 1993 (1993-05-13) & JP 04 364088 A (NEC CORP), 16. Dezember 1992 (1992-12-16)

## Beschreibung

Die Erfindung bezieht sich auf ein Verfahren zum Herstellen eines Metall-Keramik-Substrates für elektrische Schaltkreise oder Bauelemente gemäß Oberbegriff Patentanspruch 1.

Bekannt ist es, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1065 bis 1083°C, z.B. auf ca. 1071 °C;
- Abkühlen auf Raumtemperatur.

Bekannt ist weiterhin die Laserbearbeitung bzw. -behandlung von Keramik (z.B. Günter Spur "Keramikbearbeitung", Hauser Verlag, ISDN 9-446-15620-8 oder DE 4319944).

Beim Stand der Technik wird die Keramik entweder geschnitten oder durch Einzelimpulse werden in die Keramik sacklochartige Vertiefungen eingebracht, und zwar beispielsweise zum Herstellen von Sollbruchlinien, an denen ein MehrfachSubstrat in Einzelsubstrate durch Brechen getrennt werden kann. Die Laserbehandlung kann aber auch anderen Zwecken dienen. Der Abstand der Löcher beträgt dann beispielsweise 0,1 - 0,5 mm und die Eindringtiefe der Behandlung liegt zwischen 2 - 70 % der Keramikdicke.

Für die Laserbearbeitung eigenen sich beispielsweise CO2-Laser oder Nd-YA6-Laser.

Die Herstellung von Metall-Keramik-Substraten mit laserbehandelten Keramikschichten erfolgt bisher, insbesondere auch bei Verwendung des DCB-Verfahrens, wie folgt: Zunächst wird mit dem Laser die blanke, d.h. noch nicht mit einer Metallschicht versehene Keramikschicht entlang der gewünschten Sollbruchlinien behandelt. Im Anschluß daran erfolgt das Aufbringen der ersten Metallschichten, beispielsweise in Form von Kupferfolien und unter Verwendung des DCB-Verfahrens oder eines Aktivlotverfahrens. In einem weiteren Verfahrensschritt wird dann diese erste Metallschicht in der erforderlichen Weise strukturiert, und zwar unter Anwendung bekannter Ätz- und Maskierungstechniken, bei denen zunächst eine Ätzmaske beispielsweise durch Sieb- oder Fotodruck erzeugt und anschließend unter Verwendung dieser Maske durch Ätzen die erforderliche Strukturierung bzw. das erforderliche Layout hergestellt wird.

Auf der strukturierten ersten Metallschicht wird dann z.B. durch stromloses, chemisches Abscheiden in entsprechenden Bädern eine weitere Metallschicht erzeugt.

Entlang der durch die Laserbearbeitung erzeugten Sollbruchlinien kann dann das Vielfachsubstrat durch Brechen in die Einzelsubstrate unterteilt werden.

Das bekannte Verfahren, bei dem die Laserbearbeitung vor dem Aufbringen der Metallisierung erfolgt, hat den Nachteil, daß schon am Beginn des Fertigungsprozesses eine produktbezogene Laserbearbeitung von Keramiken notwendig ist und damit auch eine produktbezogene Lagerhaltung, und zwar mit dem Nachteil hoher Lagerhaltungskosten und langer Durchlaufzeiten. Weiterhin besteht die Gefahr, daß die jeweilige laserbehandelte blanke Keramik während des Aufbringens der ersten Metallschichten bzw. während des hierfür notwendigen Handling in unerwünschter Weise bricht.

Wird die Laserbearbeitung als letzten Schritt am Ende des Herstellungsprozeßes, d.h. nach dem stromlosen chemischen Abscheiden der zweiten Metallschichten vorzusehen, hat dies den Nachteil, daß die Substratoberfläche durch das Plasma, welches bei der Laserbearbeitung frei wird, stark verschmutzt. Durch längere Verweilzeiten und/oder durch die Erhitzung während der Laserbearbeitung kommt es auch in unerwünschter Weise zu einer Korrosion der Oberfläche der von den Metallschichten gebildeten Metallisierungen, was die weitere Verwendung des Substrates beeinträchtigt, beispielsweise zu einer verminderten Lötfähigkeit oder Drahtbondbarkeit der Oberfläche der Metallisierungen führt.

Versuche, die Laserbearbeitung nach dem Strukturieren der ersten Metallflächen und vor dem stromlosen bzw. chemischen Aufbringen der weiteren Metallschichten vorzunehmen, haben bisher zu keinen brauchbaren Ergebnissen geführt. Insbesondere hat sich gezeigt, daß an den Rändern und am Boden der bei der Laserbearbeitung erzeugten Ritzungen bzw. Einkerbungen oder Bohrungen bei der stromlosen, chemischen Abscheidung ebenfalls Metall abgeschieden wird. Diese unerwünschte Metallbeschichtung, die sich nach dem Trennen des Mehrfachsubstrates in die Einzelsubstrate am Rand der Einzelsubstrate befindet, führt dort zu einer Reduzierung der Spannungsfestigkeit zwischen der Oberseite und Unterseite der Einzelsubstrate.

Der Erfindung liegt die Aufgabe zugrunde, ein Verfahren aufzuzeigen, welches die Nachteile der bekannten Verfahren, insbesondere auch eine aufwendige produktbezogene Lagerhaltung von Keramiken vermeidet.

Zur Lösung dieser Aufgabe ist ein Verfahren entsprechend dem Patentanspruch 1 ausgebildet.

Bei dem erfindungsgemäßen Verfahren erfolgt die Laserbearbeitung nach der Strukturierung der wenigstens einen ersten Metallschicht und vor dem stromlosen, chemischen Aufbringen der wenigstens einen zweiten Metallschicht.

Es hat sich überraschenderweise gezeigt, daß während der stromlosen, chemischen Abscheidung der wenigstens einen weiteren Metallschicht an den Rändern und Böden der bei der Laserbehandlung erzeugten Ritzungen bzw. Einkerbunden und Vertiefungen kein Metall abgeschieden wird, wenn die Laserbearbeitung entsprechend dem erfindungsgemäßen Verfahren erfolgt, d.h. insbesondere unter einer Atmosphäre, die wenigstens 30 % Sauerstoff enthält.

Weiterbildungen der Erfindung sind Gegenstand der Unteransprüche.

Die Erfindung wird im folgenden anhand der Figuren an einem Ausführungsbeispiel näher erläutert. Es zeigen:
- Fig. 1: ein nach dem erfindungsgemäßen Verfahren hergestelltes strukturiertes Substrat;
- Fig. 2 - 7: die wesentlichen Verfahrensschritte zum Herstellen des Substrates der Figur 1.

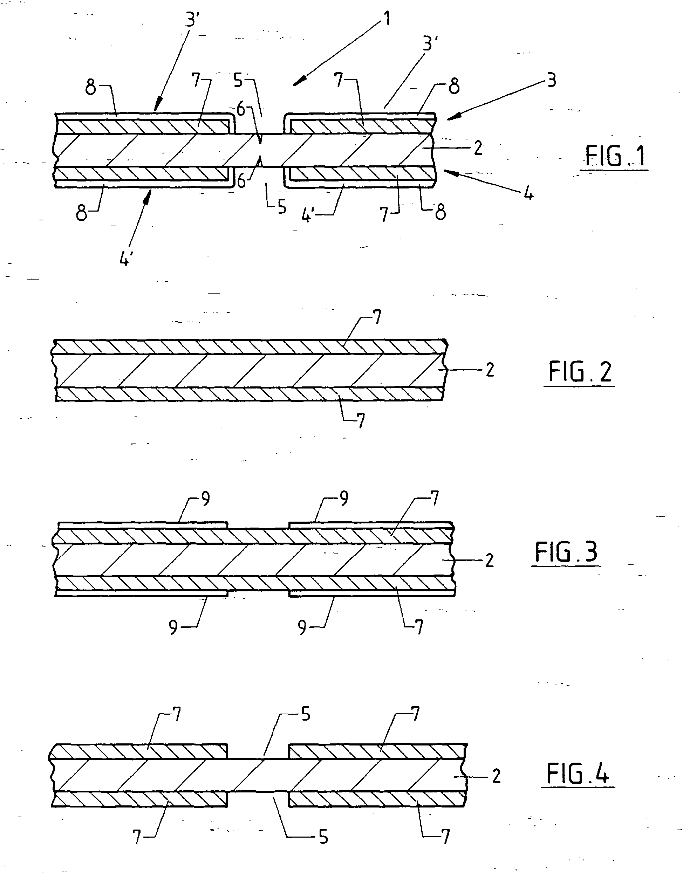

Das in der Figur 1 allgemein mit 1 bezeichnete Mehrfachsubstrat besteht im wesentlichen aus einer rechteckförmigen oder quadratischen Keramikschicht oder Keramikplatte 2, die beispielsweise eine Aluminiumoxid-Keramik oder aber eine andere Keramik, z.B. ALN, Si₃N₄ oder SiC ist. An der oberen und unteren Oberflächenseite der Keramikschicht 2 ist jeweils eine Metallisierung 3 bzw. 4 vorgesehen, die in der erforderlichen Weise strukturiert sind, und zwar bei der dargestellten Ausführungsform in der Weise, daß die Metallisierungen 3 und 4 jeweils einzelne Metallisierungen 3' bzw. 4' bilden, die an der Ober- und Unterseite der Keramikschicht in mehreren parallel zu den Umfangsseiten der Keramikschicht 2 verlaufenden Reihen und Spalten vorgesehen sind. Die einzelnen Metallisierungen 3' und 4' an der Oberseite und Unterseite der Keramikschicht 2 sind durch die Strukturierung jeweils voneinander getrennt, und zwar an streifenförmigen, parallel zu den Umfangsseiten der Keramikschicht 2 verlaufenden Bereichen 5, an denen die Keramik freiliegt. An den Bereichen 5 ist die Keramikschicht 2 weiterhin oben und unten jeweils mit von Einkerbungen 6 gebildeten Sollbruchlinien versehen. Einer Einkerbung 6 an der Oberseite der Keramikschicht 2 liegt eine Einkerbung 6 an der Unterseite dieser Keramikschicht gegenüber.

Durch die von den Einkerbungen 6 gebildeten Sollbruchlinien kann das Substrat 1 durch Brechen in Einzelsubstrate getrennt werden, die jeweils aus den Einzelmetalliesierungen 3' und 4' und dem dazwischenliegenden Teil der Keramikschicht 2 bestehen. Die Einkerbungen 6 sind durch Laserbearbeiten oder durch Laser-Ritzen, d.h. unter Verwendung eines Lasers, beispielsweise eines CO2-Lasers oder eines Nd-YA6-Lasers hergestellt. Anstelle von durchgehenden Einkerbungen 6 können auch punktförmige, jeweils in Längsrichtung des jeweiligen Bereichs 5 aufeinanderfolgende Vertiefungen oder Löcher durch Einbrennen mittels des Lasers in der Keramikschicht 2 erzeugt sein, wobei diese Löcher dann in ihrer Gesamtheit wiederum die jeweilige Sollbruchlinie bilden.

Die Metallisierungen 3 und 4 und damit auch die Einzelmetallisierungen 3' und 4' bestehen jeweils aus einer Kupferschicht 7, die flächig unmittelbar mit der betreffenden Oberflächenseite der Keramikschicht 2 verbunden ist und beispielsweise eine Dicke von 200 - 500 µ aufweist, sowie aus einer Oberflächenmetallisierung oder Metallschicht 8, die durch stromloses und chemisches Abscheiden von Metall auf der Kupferschicht 7 erzeugt ist und eine Dicke aufweist, die kleiner als die Dicke der Kupferschicht 7. Die Metallschicht 8 besteht beispielsweise aus Nickel und/oder Palladium und/oder Zinn und/oder Gold und/oder Kupfer.

Bevorzugt wird das Mehrfachsubstrat 1 so verwendet, daß die Einzelmetallisierungen 3' bzw. 4' zunächst mit einer üblichen Technik, beispielsweise Maskierungs- und Ätztechnik in der erforderlichen Weise strukturiert werden und das Mehrfachsubstrat 1 erst anschließend oder aber nach einer Bestückung mit elektrischen Bauelementen entlang der von den Einkerbungen 6 oder Löchern gebildeten Sollbruchstellen an den Bereichen 5 in die Einzelsubstrate durch Brechen zertrennt wird.

Das Herstellen des Mehrfachsubstrates 1 erfolgt beispielsweise in der nachstehend im Zusammenhang mit den Figuren 2 - 7 beschriebenen Weise:
Entsprechend Fig. 2 wird die Keramikschicht 2 an ihrer Ober- und Unterseite jeweils mit einer Kupferschicht 7 versehen, die sich zunächst über die gesamte Fläche der Ober- und Unterseite der Keramikschicht 2 erstreckt. Die Kupferschichten 7 sind beispielsweise von Kupferfolien mit einer Dicke zwischen 200 - 500 µ gebildet, die mit Hilfe der DCB-Technik oder aber mit Hilfe einer anderen, dem Fachmann bekannten Technik, beispielsweise mit Hilfe des Aktiv-Löt-Verfahrens aufgebracht sind. Grundsätzlich besteht auch die Möglichkeit, zumindest eine der beiden Kupferschichten 7 als Kupferdickschicht nach dem bekannten Dickschichtverfahren herzustellen.

Die Keramikschicht 2 kann, wie oben ausgeführt ist, eine Keramik unterschiedlichen Typs sein, z.B. AL₂O₃, ALN, Si₃N_{4,} SiC.

Entsprechend den Figuren 3 und 4 erfolgt in weiteren Verfahrensschritten die Strukturierung der Kupferschichten 7, insbesondere zur Herstellung der Bereiche 5, an denen die Keramikschicht 2 dann freiliegt und von denen bei der dargestellten Ausführungsform jeweils ein Bereich 5 an der Oberseite der Keramikschicht 2 einem Bereich 5 an der Unterseite der Keramikschicht 2 gegenüberliegt. Diese Strukturierung erfolgt mit der bekannten Ätztechnik. Hierzu wird auf die freiliegenden Oberflächenseiten der Kupferschichten 7 jeweils eine Schicht aus einem Fotolack aufgebracht, der eine Ätz-Maske 9 bildet, die die Kupferschichten 7 an den nicht zu ätzenden Brechen abdeckt. Durch Ätzen und anschließendes Entfernen der Maske 9 werden die Bereiche 5 in den Kupferschichten 7 erzeugt, an denen die Keramikschicht 2 freiliegt.

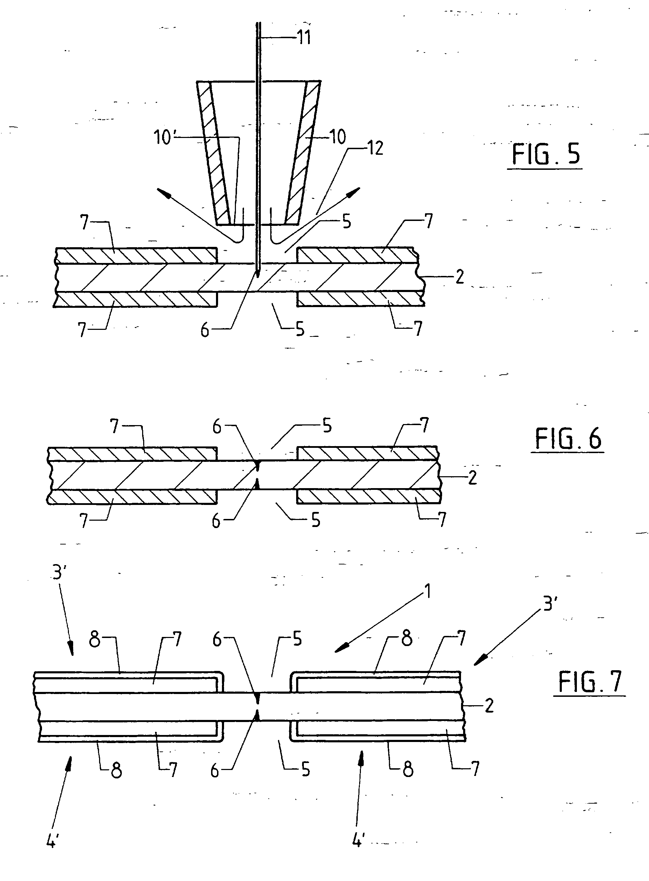

In einem weiteren Verfahrensschritt erfolgt entsprechend der Figur 5 die Laserbearbeitung, d.h. das Einbringen der Einkerbungen 6 bzw. der entsprechenden Löcher zumindest an der einen Oberflächenseite der Keramikschicht 2 entlang der dortigen Bereiche 5. Bei der dargestellten Ausführungsform erfolgt diese Laserbearbeitung auf beiden Seiten der Keramikschicht 2, und zwar beispielsweise zunächst an der Oberseite und dann nach einem Wenden auch an der Unterseite, so daß das in der Figur 6 dargestellte Ergebnis erhalten wird. Wesentlich hierbei ist, daß die Laserbearbeitung in einer Atmosphäre erfolgt, die einen hohen Anteil an Sauerstoff, d.h. mindestens 30 - 35% Sauerstoff enthält. Hierfür wird für die Laserbearbeitung eine Düse 10 verwendet, durch die der Laserstrahl 11 hindurchgeführt ist und an der ein Gasstrom 12 austritt und unmittelbar auf den Bereich auftrifft, an dem die Behandlung der Keramikschicht 2 mit dem Laserstrahl 11 gerade durchgeführt wird. Der Gasstrom 12 ist beispielsweise mit Sauerstoff angereicherte Luft oder aber technischer Sauerstoff.

Es hat sich gezeigt, daß durch die Laserbearbeitung in der Sauerstoffatmosphäre offenbar Keime im Bereich der Einkerbungen 6 wirksam verhindert werden, die bei dem späteren stromlosen bzw. chemischen Aufbringen der Metallschicht 8 ein unerwünschtes Abscheiden von Metall an den Einkerbungen 6 bewirken könnten.

Die Düse 10 ist mit ihrem unteren, offenen Düsenende 10' möglichst dicht am Substrat angeordnet, beispielsweise in einem Abstand von höchstens 5 mm. Der Druck in der Düse 10 beträgt wenigstens 50 Kilo-Pascal.

Entsprechend der Figur 7 wird dann in einem stromlosen Verfahrenschritt chemisch die Metallschicht 8 abgeschieden, und zwar nur dort, wo dieses Substrat für die chemische Abscheidung aktiviert ist, nämlich auf den freiliegenden Oberflächen der strukturierten Kupferschicht 7. Durch die Beaufschlagung der Oberfläche der Keramikschicht 2 bei der Laserbearbeitung mit Sauerstoff erfolgt bei diesem stromlosen, chemischen Metallauftrag an den Bereichen 5 und auch an den Einkerbungen 6 kein Metallauftrag, so daß insbesondere auch für die hergestellten Einzelsubstrate die erforderliche Spannungsfestigkeit gegeben ist, obwohl die Laserbearbeitung zur Erzielung der Sollbruchlinien (Einkerbungen 6 oder Laser-Löcher) erst nach dem Aufbringen der Kupferschichten 7 und deren Strukturierung vorgenommen wird. Das vorbeschriebene Verfahren bietet insbesondere auch den Vorteil, daß unter Verwendung von mit den Kupferschichten 7 bereits versehenen Keramikschichten 2 das Layout des jeweiligen Mehrfachsubstrates 1 bzw. die Herstellung der Einzelmetallisierungen 3' und 4' jeweils individuell den speziellen Anforderungen oder Kundenwünschen entsprechend erfolgen kann, was nicht möglich wäre, wenn die Sollbruchlinien bzw. die entsprechenden Einkerbungen 6 oder Laser-Löcher bereits vor dem Aufbringen der ersten, flächigen Metallschicht (Kupferschichten 7) und vor dem Strukturieren dieser Metalliesierung erfolgen würde.

Zu dem vorbeschriebenen Verfahren sind verschiedene Modifikationen oder zusätzliche Verfahrensschritte denkbar. So ist es beispielsweise möglich, vor dem stromlosen, chemischen Metallauftrag (Metallschicht 8), bevorzugt nach der Laserbearbeitung die Oberfläche des Substrates und dabei insbesondere auch dessen Kupferoberfläche durch eine alkalische Behandlung zu reinigen und/oder bei der Laserbearbeitung entstandene Reste zu entfernen und/oder die Oberfläche der Kupferschichten 7 geringfügig abzuätzen, wobei die Dicke der bei diesem Abätzen entfernten Kupferteilschicht z.B. 0,1 - 50 µ beträgt.

Anstelle dieser Oberflächenbehandlung oder zusätzlich hierzu ist es weiterhin auch möglich, die Oberfläche der Kupferschichten 7, auf denen die Metallschicht 8 chemisch und stromlos abgeschieden werden soll, hierfür in geeigneter Weise zu aktivieren.

Für den stromlosen, chemischen Metallauftrag eignet sich beispielsweise Ni-Phosphor oder Ni-Bohr mit Palladium-Chlorid eine Aktivierung aber auch chemisch abgeschiedenes Zinn und/oder Kupfer.

Weiterhin besteht auch die Möglichkeit, auf die Metallschicht 8 wenigstens eine weitere Metallschicht aufzubringen, und zwar wiederum durch stromlosen, chemischen Metallauftrag. Diese weitere Metallschichten können dann beispielsweise Gold, Palladium usw. sein.

Wie Fig. 5 verdeutlicht wird durch die Strukturierung der Kupferschicht 7 bei der Laserbearbeitung der aus der Düse 10 ausgebrachte Sauerstoff im jeweiligen Bereich 5 gegen zu schnelles Entweichen zurückgehalten, so daß sich eine relativ lange Verweilzeit für den Sauerstoff am Ort der Laserbearbeitung erreicht wird.

Die Erfindung wurde voranstehend an Ausführungsbeispielen beschrieben. Es versteht sich, daß weitere Abwandlungen möglich sind, ohne daß der der Erfindung zugrundeliegende Erfindungsgedanke verlassen wird.

### Bezugszeichenliste

- 1: Mehrfachsubstrat
- 2: Keramikschicht
- 3, 4: Metallisierung
- 3', 4': Einzelmetallisierung
- 5: freiliegender Bereich der Keramikschicht
- 6: Einkerbung
- 7: Kupferschicht
- 8: Metallschicht
- 9: Maske
- 10: Düse
- 10': Düsenöffnung
- 11: Laserstrahl
- 12: Gasstrahl mit hohem Sauerstoffanteil

## Patentansprüche

1. Verfahren zum Herstellen eines Metall-Keramik-Substrates, bei dem wenigstens eine Oberflächenseite einer Keramikschicht (2) mit wenigstens einer ersten, strukturierten Metallschicht (7) versehen und auf diese erste, strukturierte Metallschicht (7) durch stromloses, chemisches Abscheiden wenigstens eine zweite Metallschicht (8) aufgebracht wird, und bei dem in die Keramikschicht (2) durch Laserbearbeitung wenigstens eine eine Sollbruchlinie bildende Einkerbung (6) und/oder eine Vielzahl von aneinander anschließenden, die Sollbruchlinie bildenden Löchern oder Vertiefungen eingebracht werden, **dadurch gekennzeichnet, daß** die Laserbearbeitung nach dem Herstellen der ersten, strukturierten Metallschicht (7) erfolgt, und zwar in einer Atmosphäre, die mindestens 30% Sauerstoff enthält.

2. Verfahren nach Anspruch 1, **dadurch gekennzeichnet, daß** beide Oberflächenseiten der Keramikschicht (2) jeweils mit der ersten, strukturierten Metallschicht (7) versehen werden und auf wenigstens eine erste Metallschicht (7) die wenigstens eine zweite Metallschicht (8) stromlos abgeschieden wird.

3. Verfahren nach Anspruch 1 oder 2, **dadurch gekennzeichnet, daß** an beiden Oberflächenseiten der Keramikschicht jeweils eine Laserbearbeitung erfolgt.

4. Verfahren nach einem der vorhergehenden Ansprüche, **dadurch gekennzeichnet, daß** die erste Metallschicht (7) durch eine Ätz- und Maskierungstechnik strukturiert wird.

5. Verfahren nach einem der vorhergehenden Ansprüche, **dadurch gekennzeichnet, daß** die erste Metallschicht (7) in Form einer Metallfolie mittels des Direct-Bonding-Verfahrens oder unter Verwendung eines Aktiv-Löt-Verfahrens aufgebracht wird, und/oder daß die erste Metallschicht (7) mit Hilfe einer Dickschichttechnik aufgebracht wird.

6. Verfahren nach einem der vorhergehenden Ansprüche, **dadurch gekennzeichnet,**
**daß** die erste Metallschicht (7) aus Kupfer oder einer Kupferlegierung besteht, und/oder
**daß** die erste Metallschicht (7) mit einer Dicke von 200 - 500 µm aufgebracht wird, und/oder
**daß** die Keramikschicht (2) aus wenigstens einer Keramik der Gruppe Al₂O₃, AlN, Si₃N₄, Sic besteht.

7. Verfahren nach einem der vorhergehenden Ansprüchen, **dadurch gekennzeichnet, daß** für die Laserbearbeitung ein Laser mit einer Wellenlänge von etwa 10 µm beispielsweise 10,6 µm, z.B. ein CO₂-Laser, oder ein Laser mit einer Wellenlänge von etwa 1 µm beispielsweise 1,06 µm, z.B. ein Nd-YA6-Laser verwendet wird.

8. Verfahren nach einem der vorhergehenden Ansprüchen, **dadurch gekennzeichnet, daß** das Substrat vorzugsweise nach der Laserbearbeitung chemisch und/oder mechanisch gereinigt wird, wobei beispielsweise die Reinigung durch alkalische Behandlung und/oder durch Abätzen einer dünnen Oberflächenteilschicht der ersten Metallschicht erfolgt.

9. Verfahren nach einem der vorhergehenden Ansprüchen, **dadurch gekennzeichnet, daß** vor dem chemischen Abscheiden der wenigstens einen zweiten Metallschicht eine Aktivierung der Oberfläche der ersten Metallschicht erfolgt.

10. Verfahren nach einem der vorhergehenden Ansprüchen, **dadurch gekennzeichnet, daß** die chemische Abscheidung bzw. Metallisierung unter Verwendung von Ni-Phospor oder Ni-Bohr mit Aktivierung durch Palladiumchlorid/ oder durch chemisches Zinn- und/oder chemisches Kupfer erfolgt.

11. Verfahren nach einem der vorhergehenden Ansprüche, **dadurch gekennzeichnet, daß** zumindest auf einem Teil der zweiten Metallschicht (8) durch eine chemische stromlose Abscheidung wenigstens eine weitere Metallschicht (8) erzeugt wird.

12. Verfahren nach einem der vorhergehenden Ansprüchen, **dadurch gekennzeichnet, daß** als zweite Metallschicht (8) und/oder als weitere Metallschicht Gold und/oder Palladium durch chemisches Abscheiden aufgebracht wird.

13. Verfahren nach einem der vorhergehenden Ansprüchen, **dadurch gekennzeichnet, daß** die Laserbehandlung in einem Luft- oder Gasstrom, der mit Sauerstoff angereichert ist, oder in einem Strom aus Sauerstoff bzw. technischen Sauerstoff erfolgt.

14. Verfahren nach einem der vorhergehenden Ansprüchen, **dadurch gekennzeichnet, daß** die Laserbearbeitung durch eine Düse (10) erfolgt, aus deren Öffnung zusätzlich zum Laserstrahl (11) auch der Luft- oder Gasstrom (12) austritt, wobei beispielsweise bei der Laserbehandlung der Abstand der Düse zum Substrat gleich oder kleiner 5 mm ist und/oder die Düse mit einem Gasdruck von wenigstens 50 kPa beaufschlagt ist.

## Claims

1. Method for manufacturing a metal-ceramic substrate in which at least one surface side of a ceramic layer (2) is provided with at least a first structured metal layer (7) and at least a second metal layer (8) is applied to this first structured metal layer (7) through currentless chemical precipitation, and in which through laser treatment at least one notch (6) forming an ideal break line and/or a number of successive holes or indentations forming the ideal break line is/are formed in the ceramic layer (2) **characterised in that** the laser treatment is carried out after the first structured metal layer (7) has been manufactured, namely in an atmosphere which contains at least 30% oxygen.

2. Method according to claim 1 **characterised in that** the two surface sides of the ceramic layer (2) are each provided with the first structured metal layer (7), and the at least one second metal layer (8) is deposited without current onto at least one first metal layer (7).

3. Method according to claim 1 or 2 **characterised in that** laser treatment is carried out on both surfaces of the ceramic layer.

4. Method according to one of the preceding claims **characterised in that** the first metal layer (7) is structured through etching and masking technology.

5. Method according to one of the preceding claims **characterised in that** the first metal layer (7) is applied in the form of a metal foil by means of the direct bonding process or by using an active soldering process and/or that the first metal layer (7) is applied by means of a thick layer procedure.

6. Method according to one of the preceding claims **characterised in that** the first metal layer (7) is made of copper or a copper alloy and/or that the first metal layer (7) is applied to a thickness of 200 to 500 µm and/or that the ceramic layer (2) is made of at least one ceramic of the group Al₂O₃, AlN, Si₃N₄, Sic.

7. Method according to one of the preceding claims **characterised in that** for the laser treatment a laser is used having a wave length of about 10µm, by way of example 10.6µm, e.g. a CO₂ -laser or a laser having a wave length of about 1µm, by way of example 1.06µm, e.g. an Nd-YA6-laser.

8. Method according to one of the preceding claims **characterised in that** the substrate is chemically and/or mechanically cleaned preferably after the laser treatment whereby for example the cleaning is carried out through alkaline treatment and/or through etching a thin surface layer part of the first metal layer.

9. Method according to one of the preceding claims **characterised in that** prior to the chemical precipitation of the at least one second metal layer an activation of the surface of the first metal layer is carried out.

10. Method according to one of the preceding claims **characterised in that** the chemical precipitation or metal-plating is carried out by using Ni-phosphorus or Ni-Bohr with activation through palladium chloride /or through chemical tin and/or chemical copper.

11. Method according to one of the preceding claims **characterised in that** at least a further metal layer (8) is produced on at least a part of the second metal layer (8) through a chemical currentless precipitation.

12. Method according to one of the preceding claims **characterised in that** gold and/or palladium is/are applied as the second metal layer (8) and/or as the additional metal layer.

13. Method according to one of the preceding claims **characterised in that** the laser treatment is carried out in an air or gas stream which is enriched with oxygen, or in a stream of oxygen or technical oxygen.

14. Method according to one of the preceding claims **characterised in that** the laser treatment is carried out through a nozzle (10) from the opening of which the air or gas stream (12) exits same in addition to the laser beam (11), wherein by way of example during the laser treatment the distance of the nozzle from the substrate is equal to or less than 5 mm and/or the nozzle is loaded with a gas pressure of at least 50 kPa.

## Revendications

1. Procédé de fabrication d'un substrat en métal-céramique dans lequel au moins un côté superficiel d'une couche de céramique (2) est pourvu d'au moins une première couche de métal structurée (7) et au moins une deuxième couche de métal (8) est appliquée sur cette première couche de métal structurée (7) par dépôt chimique sans courant, et dans lequel au moins une entaille formant une ligne destinée à la rupture et / ou une pluralité de trous ou dépressions se raccordant les uns aux autres et formant la ligne destinée à la rupture sont pratiqués dans la couche de céramique (2) par usinage par laser, **caractérisé en ce que** l'usinage par laser a lieu après la production de la première couche de métal structurée (7) et en fait dans une atmosphère qui contient au moins 30 % d'oxygène.

2. Procédé selon la revendication 1, **caractérisé en ce que** les deux côtés superficiels de la couche de céramique (2) sont pourvus respectivement de la première couche de métal structurée (7) et ladite au moins deuxième couche de métal (8) est déposée sans courant sur au moins une première couche de métal (7).

3. Procédé selon la revendication 1 ou 2, **caractérisé en ce qu'**un traitement au laser a lieu respectivement sur les deux côtés superficiels de la couche céramique.

4. Procédé selon l'une des revendications précédentes, **caractérisé en ce que** la première couche de métal (7) est structurée par une technique de gravure et de masquage.

5. Procédé selon l'une des revendications précédentes, **caractérisé en ce que** la première couche de métal (7) est appliquée sous la forme d'un film métallique au moyen du procédé de Direct Bonding (liaison directe) ou en utilisant un procédé de brasage actif, et / ou la première couche de métal (7) est appliquée à l'aide d'une technique de couche épaisse.

6. Procédé selon l'une des revendications précédentes,
**caractérisé**
**en ce que** la première couche de métal (7) est constituée de cuivre ou d'un alliage de cuivre, et / ou
**en ce que** la première couche de métal (7) est appliquée en une épaisseur de 200 - 500 µm, et / ou
**en ce que** la couche de céramique (2) est constituée d'au moins une céramique du groupe Al₂O₃, AlN, Si₃N₄, SiC.

7. Procédé selon l'une des revendications précédentes, **caractérisé en ce qu'**un laser avec une longueur d'onde d'environ 10 µm, par exemple de 10,6 µm, par exemple un laser CO₂, ou un laser avec une longueur d'environ 1 µm, par exemple de 1,06 µm, par exemple un laser Nd - YA6 est utilisé pour l'usinage par laser.

8. Procédé selon l'une des revendications précédentes, **caractérisé en ce que** le substrat est nettoyé chimiquement et/ou mécaniquement de préférence après l'usinage par laser, le nettoyage ayant lieu par exemple par traitement alcalin et / ou par décapage d'une couche partielle superficielle de la première couche de métal.

9. Procédé selon l'une des revendications précédentes, **caractérisé en ce qu'**une activation de la surface de la première couche de métal a lieu avant le dépôt chimique de ladite au moins deuxième couche de métal.

10. Procédé selon l'une des revendications précédentes, **caractérisé en ce que** le dépôt chimique ou encore la métallisation a lieu en utilisant du Ni-phosphore ou du Ni-bore avec activation par du chlorure de palladium et/ou par de l'étain chimique et/ou du cuivre chimique.

11. Procédé selon l'une des revendications précédentes, **caractérisé en ce qu'**au moins une couche de métal supplémentaire (8) est produite par un dépôt chimique sans courant au moins sur une partie de la deuxième couche de métal (8).

12. Procédé selon l'une des revendications précédentes, **caractérisé en ce que** de l'or et/ou du palladium est appliqué par dépôt chimique comme deuxième couche de métal (8) et / ou comme couche de métal supplémentaire.

13. Procédé selon l'une des revendications précédentes, **caractérisé en ce que** l'usinage par laser a lieu dans un courant d'air ou de gaz qui est enrichi en oxygène, ou dans un courant d'oxygène ou encore d'oxygène technique.

14. Procédé selon l'une des revendications précédentes, **caractérisé en ce que** l'usinage par laser a lieu par une buse de l'ouverture de laquelle sort aussi, outre le faisceau laser (11), le courant d'air ou de gaz (12), la distance de la buse par rapport au substrat étant égale ou inférieure à 5 mm et / ou la buse étant soumise à une pression de gaz d'au moins 50 kPa lors de l'usinage par laser.
